# EUROPEAN PATENT APPLICATION

(11) **EP 2 365 347 A1**
(43) Date of publication of application: **14.09.2011**
(21) Application number: 09825788.4
(22) Date of filing: 23.09.2009
(51) Int. Cl.: G01R 29/08, G01R 29/12

(54) **ELECTRICAL FIELD SENSOR**

(30) Priority: 12.11.2008 ES 200803231
(71) Applicant: Instituto De Tecnología Eléctrica, ITE, 46980 Paterna (Valencia) (ES)
(72) Inventor: QUIJANO LÓPEZ, Alfredo, E-46980 Paterna (Valencia) (ES); LLOVERA SEGOVIA, Pedro, E-46980 Paterna (Valencia) (ES)
(74) Representative: Ungria Lopez, Javier
(86) International application number: PCT/ES2009/070396
(87) International publication number: WO 2010/055180

(57) **Abstract**

It has a floating electrode (2) that is located in small areas of its surface on an insulator (4) attached to a control electrode (3) provided with an opening in which an electrostatic probe (6) with shielding (5) that allows measuring the surface potential without physical contact is applied and which is connected to a measuring block (7) that is in turn connected to an attenuator (8) attached to a controlled high voltage source (9) connected to the control electrode (3).

## Description

### OBJECT OF THE INVENTION

The present invention, as this specification states In the title, relates to an electrical field sensor based on a virtually floating electrode and purpose of which consists of providing a continuous and low frequency electrical field meter that overcomes the drawbacks of the electrical field meters of the state of the art such as lack of stability or requiring mechanical elements. For this purpose, the invention employs a floating electrode on a control electrode provided with an opening in which an electrostatic probe is applied, providing potential measurements in the control electrode without mechanical components and physical contact, so that the measurements do not cause the discharge of the control electrode and the introduction of eddy current therein that could overlap the measurements made.

### BACKGROUND OF THE INVENTION

The measurement of static or low frequency atmospheric electrical field exhibits some technical difficulties to be performed. The simplest method that is commonly used for high frequencies, e.g. greater than 50 Hz, consists of using a capacitive sensor with a floating conductive plate. The atmospheric electrical field induces a charge on the plate that depends on the electrical field. Thus, it is sufficient to measure the charge of that electrode, integrating the current with a capacitor or with electrical charge measuring equipment. This method has drawbacks related to the corresponding measuring electrode is always discharged by leakage current, determining unstable measurements and producing long-term errors.

Said leakage currents are mainly due to the following two causes:
- The electronic equipments used to measure the electrical charge have leaks due to the bias currents needed for whether measuring the charge of a capacitor connected to the electrode as integrating the current of the electrode itself.
   The floating plate should be located on an insulator that separates it from ground and the insulator always has leakage currents that discharge the sensor, invalidating the corresponding measurement, which is a problem that has been partially resolved by using MOSFET-type sensors with feedback, but still. there are still drawbacks relating to only achieve a few seconds or minutes of stability.

In order to avoid the referred drawbacks the systems for measuring the electrical field by using capacitive sensor, the equipments so-called "field mill" that operate on a similar principle, i.e., measuring the charge on an conductor electrode, but with the difference that makes the electrical field exposure by placing that conductor electrode after a grounded rotating electrode, are currently used. Thus, the electrical field incident on the sensor surface is alternate and has fewer problems with an integrated circuit. The main drawbacks of these "field mill" equipments consists of using a mechanical motor-rotation system that introduces problems related to maintenance and equipment life, further causing other problems relating to the noise and vibrations produced.

### DESCRIPTION OF THE INVENTION

To achieve the objectives and avoid the drawbacks mentioned in previous sections, the Invention consists of an electrical field sensor for measuring continuous and low frequency electrical fields.

Novelty, according to the invention, the measuring sensor or device of said invention comprises a floating electrode that is placed in small areas of its surface on an insulator attached to a control electrode provided with an opening in which an electrostatic probe with shielding that allows performing surface potential measurements without physical contact is applied, and which is connected to a measuring block that is in turn connected to an attenuator attached to a controlled high voltage source connected to the control electrode, thereby providing potential measurements on the control electrode without mechanical components and without physical contact, so that the measurement does not cause the discharge of said control electrode and the introduction therein of eddy current that could overlap the measurements made.

According to a preferred embodiment of the invention, the aforementioned insulator is an insulator with low surface conductivity and volume, and low polarization with respect to the absorption current. Moreover, in this preferred embodiment of the invention, the aforementioned electrostatic probe is based on a vibrating electrode by oscillator with feedback system that controls the potential of the measuring electrode itself. However, other embodiments may employ other type of insulator and other type of probe.

With the structure described above, the electrical field sensor of the invention has the following main advantages:
- allows measuring the potential of the floating plate or electrode without contact, and therefore without discharging that plate and introducing no eddy currents that could overlap with the measurements themselves.
   Allows the discharge currents characteristic of the floating electrode or plate to be zero by controlling a potential that virtually cancels the potential difference to ground.
- Depending on the response times of the probe and the floating potential control system determined by the attenuator and the high voltage source, the frequency response of the meter or sensor of the invention can range from continuous electrical field to a limiting frequency that can reach the order of KHz.

Then, to facilitate a better understanding of this specification and being an integral part thereof, a single figure wherein the object of the invention has been represented in an illustrative and not limitative manner is attached.

### BRIEF DESCRIPTION OF THE DRAWING

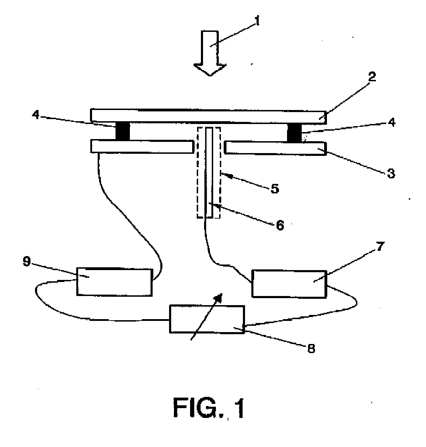

**Figure 1**.- Represents a functional block diagram of an electrical field sensor made according to the present invention.

### DESCRIPTION OF AN EMBODIMENT OF THE INVENTION

A description of an example of the invention with reference to the numbering adopted in the figure is now made.

Thus, the sensor of the present example allows measuring continuous and low frequency electrical fields 1.

Receiving that electrical field 1 is a floating electrode 2 attached through small areas of its surface to an insulator 4, which is in turn attached to a control electrode 3, such as shown in Figure 1.

The control electrode 3 has an opening in which an electrostatic probe 6 with shielding 5 is applied for measuring the surface potential without physical contact, and which is connected to a measuring block 7 connected in series with an attenuator 8 and with a controlled high voltage source 9 electrically connected to the control electrode 3, such as shown in Figure 1.

This configuration allows:
- Measuring the potential of the floating plate or electrode 2 without contact, and therefore without discharging the plate and introducing eddy currents that overlap with the measurement.
- Cancelling the discharge current of the floating electrode 2 by controlling a potential that virtually cancels the potential difference to ground.
- That depending on the response times of the probe and control system of the remaining potential (attenuator 8 and high voltage source 9) the frequency response of the sensor or meter will range from continuous electrical field to a limiting frequency that can reach the KHz.

The measuring procedure used in Figure 1 consists in that the floating electrode 2 is located on the insulator 4 that is an insulator with low surface conductivity and volume and low polarization (absorption currents). However, in other embodiments, the invention allows the use of all types of insulators, since it cancels its response. The potential measurement is performed by a probe 6 for measuring the surface potential without contact, which does not affect the potential of the measured plate. Said probe 6 is conventional and is based on a vibrating electrode through an oscillator and a feedback system that controls the potential of the measuring electrode itself as being able to use other types of probes 6 in other embodiments.

## Claims

1. Electrical field sensor, for measuring continuous and low frequency electrical fields (1); **characterized in that** it comprises a floating electrode (2) that is located in small areas of its surface on an insulator (4) attached to a control electrode (3) provided with an opening in which an electrostatic probe (6) with shielding (5) that allows measuring the surface potential without physical contact is applied, and which is connected to a measuring block (7) that is in turn connected to an attenuator (8) attached to a controlled high voltage source (9) connected to the control electrode (3); thereby providing potential measurements in the control electrode (3) without mechanical components and with no physical contact, so that the measurement does not cause the discharge of said control electrode (3) or the introduction of eddy currents therein that could overlap with the measurements made.

2. Electrical field sensor, according to claim 1, **characterized in that** said insulator (4) is an insulator with low surface conductivity and volume and low polarization from absorption currents.

3. Electrical field sensor, according to claim 1, **characterized in that** said electrostatic probe (6) is based on a vibrating electrode through oscillator with feedback system that controls the potential of the measuring electrode itself.
